(19) Europäisches Patentamt / European Patent Office / Office européen des brevets

(11) **EP 4 322 344 B1**

(12) **EUROPEAN PATENT SPECIFICATION**

(45) Date of publication and mention
of the grant of the patent:
**15.07.2026  Bulletin 2026/29**

(21) Application number: **22784409.9**

(22) Date of filing: **09.03.2022**

(51) International Patent Classification (IPC):
*H01S 1/06* (2006.01)    *G04F 5/14* (2006.01)
*H03L 7/26* (2006.01)    *G01C 19/62* (2006.01)
*G01R 33/26* (2006.01)    *G01V 7/00* (2006.01)
*G01V 7/14* (2006.01)    *G06N 10/40* (2022.01)
*G21K 1/00* (2026.01)    *H05H 3/02* (2006.01)
*H05H 3/04* (2006.01)

(52) Cooperative Patent Classification (CPC):
**G04F 5/14; G01C 19/58; G01C 19/62; G01R 33/26;
G21K 1/30; H01S 1/06; H03L 7/26;** G01V 7/00;
G06N 10/40

(86) International application number:
**PCT/JP2022/010404**

(87) International publication number:
**WO 2022/215424 (13.10.2022 Gazette 2022/41)**

(54) **SLOW ATOMIC BEAM GENERATOR, PHYSICAL PACKAGE, PHYSICAL PACKAGE FOR OPTICAL LATTICE CLOCK, PHYSICAL PACKAGE FOR ATOMIC CLOCK, PHYSICAL PACKAGE FOR ATOMIC INTERFEROMETER, PHYSICAL PACKAGE FOR QUANTUM INFORMATION PROCESSING DEVICE, AND PHYSICAL PACKAGE SYSTEM**

LANGSAMER ATOMSTRAHLGENERATOR, PHYSIKALISCHES GEHÄUSE FÜR OPTISCHEN GITTER, PHYSIKALISCHES GEHÄUSE

GÉNÉRATEUR DE FAISCEAU ATOMIQUE LENT, EMBALLAGE PHYSIQUE, EMBALLAGE PHYSIQUE POUR HORLOGE À RÉSEAU OPTIQUE, EMBALLAGE PHYSIQUE POUR HORLOGE ATOMIQUE, EMBALLAGE PHYSIQUE POUR INTERFÉROMÈTRE ATOMIQUE, EMBALLAGE PHYSIQUE POUR DISPOSITIF DE TRAITEMENT D'INFORMATIONS QUANTIQUES ET SYSTÈME D'EMBALLAGE PHYSIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **08.04.2021  JP 2021066149**

(43) Date of publication of application:
**14.02.2024  Bulletin 2024/07**

(73) Proprietors:
• **JEOL Ltd.**
  **Akishima, Tokyo 196-8558 (JP)**
• **RIKEN**
  **Wako, Saitama 351-0198 (JP)**

(72) Inventors:
• **TSUJI, Shigenori**
  **Akishima, Tokyo 196-8558 (JP)**
• **TAKAMOTO, Masao**
  **Wako, Saitama 351-0198 (JP)**
• **KATORI, Hidetoshi**
  **Wako, Saitama 351-0198 (JP)**

(74) Representative: **Boult Wade Tennant LLP
Salisbury Square House
8 Salisbury Square
London EC4Y 8AP (GB)**

(56) References cited:
WO-A1-2014/027637    CN-A- 109 781 088
JP-A- 2020 141 401    US-B1- 6 303 928

- SEAN RAVENHALL ET AL: "A high-flux, adjustable, compact cold-atom source", ARXIV.ORG, CORNELL UNIVERSITY LIBRARY, 201 OLIN LIBRARY CORNELL UNIVERSITY ITHACA, NY 14853, 30 January 2021 (2021-01-30), XP081871164
- RAVENHALL SEAN: "A Compact, High-Flux Source of Cold Atoms", 1 January 2018 (2018-01-01), Oxford, UK, pages 1 - 200, XP093254055, Retrieved from the Internet <URL:https://ora.ox.ac.uk/objects/ uuid:19c66173-84a3-4682-8708-45d1e47db069/ files/m667eebae53cd73f9d706dc9b3f392fcd>
- MERIMECHE HABIB: "Slow Atomic Beams Manipulation with Magnetic Videotapes", 4 March 2004 (2004-03-04), Bonn, Germany, pages 1 - 101, XP093254061, Retrieved from the Internet <URL:https://bonndoc.ulb.uni-bonn.de/xmlui/ bitstream/handle/20.500.11811/2025/0335.pdf? sequence=1&isAllowed=y>
- IAN R HILL ET AL: "Zeeman slowers for strontium based on permanent magnets", JOURNAL OF PHYSICS B, ATOMIC MOLECULAR AND OPTICAL PHYSICS, INSTITUTE OF PHYSICS PUBLISHING, BRISTOL, GB, vol. 47, no. 7, 26 March 2014 (2014-03-26), pages 75006, XP020260002, ISSN: 0953-4075, [retrieved on 20140326], DOI: 10.1088/0953-4075/47/7/075006
- LISON F. ET AL: "High-brilliance Zeeman-slowed cesium atomic beam", vol. 61, no. 1, 1 December 1999 (1999-12-01), USA, XP093254056, ISSN: 1050-2947, Retrieved from the Internet <URL:https://journals.aps.org/pra/pdf/10.1103/ PhysRevA.61.013405> DOI: 10.1103/ PhysRevA.61.013405
- C. W. OATES ; C. W. HOYT ; Y. LE COQ ; Z. W. BARBER ; T. M. FORTIER ; J. E. STALNAKER ; S. A. DIDDAMS ; L. HOLLBERG: "Stability Measurements of the Ca and Yb Optical Frequency Standards", INTERNATIONAL FREQUENCY CONTROL SYMPOSIUM AND EXPOSITION, 2006 IEEE, 1 June 2006 (2006-06-01), Pi , pages 74 - 79, XP031003669, ISBN: 978-1-4244-0074-4

**Description**

TECHNICAL FIELD

The present disclosure relates to a slow atomic beam generation apparatus, a physical package, a physical package for an optical lattice clock, a physical package for an atomic clock, a physical package for an atomic interferometer, a physical package for a quantum information processing device, and a physical package system.

BACKGROUND

An optical lattice clock is an atomic clock which was proposed in the year 2001 by Hidetoshi Katori, one of the inventors of the present disclosure. In the optical lattice clock, atoms are entrapped within an optical lattice formed by laser light, and a resonance frequency of a visible light region is measured. Because of this, the optical lattice clock enables measurement with a precision of 18 digits, far exceeding precision of cesium clocks which are presently available. The optical lattice clocks are now eagerly being researched and developed by the group of the present inventors, and also by various groups in and out of Japan, and are now emerging as next-generation atomic clocks.

As recent techniques for the optical lattice clock, for example, Patent Literatures 1 to 3 described below may be exemplified. Patent Literature 1 describes that a one-dimensional moving optical lattice is formed inside an optical waveguide having a hollow passageway. Patent Literature 2 describes a configuration in which an effective magic frequency is set. In fact, a magic wavelength is theoretically and experimentally determined for strontium, ytterbium, mercury, cadmium, magnesium, and the like. Patent Literature 3 describes a radiation shield which reduces influences from black body radiation emanating from the walls at the periphery.

In the optical lattice clock, in order to perform time measurement with high precision, an altitude difference of 1 cm on the earth based on a general relatively effect due to the force of gravity can be detected as a deviation of progression of time. Thus, if the optical lattice clock can be made smaller and portable so that the optical lattice clock may be used in fields outside of a research laboratory, application possibilities can be widened for new geodetic techniques such as search for underground resources, underground openings, detection of magma reservoirs, and the like. By producing the optical lattice clocks on a massive scale and placing them in various places to continuously monitor a variation in time of the gravity potential, applications may be enabled such as detection of crustal movement and spatial mapping of a gravity field. In this manner, optical lattice clocks are expected to contribute to society as a new fundamental technology, beyond a frame of highly precise time measurement.

In recent years, research has been carried out for precision atomic measurement apparatuses using slow atoms cooled to a temperature close to absolute zero by laser light. In such precision measurement apparatuses, it is important to efficiently generate a slow atomic beam with a high flow rate.

An example of the apparatus that utilizes a slow atom generator is the optical lattice clock described above. In addition, neutral atoms cooled to a very low temperature have attracted much attention as qubits for a basic unit of quantum information. Quantum computers that use cooled atomic gases as qubits are less affected by the surrounding environment than quantum computers that use electron spins or nuclear spins in solids or liquids. Because of this, it is possible to retain the quantum information for a long period of time. Further, advantages are expected such as that the number of qubits can be increased using Bose-Einstein condensation techniques.

In recent years, application of a magneto-optical trap method (MOT) has been attempted for a plurality of different energy levels for the atoms.

Non-Patent Literature 1 describes an experiment in which a magneto-optical trap using a transition from a ground state $^1S_0$ to an excited state $^1P_1$ for calcium (Ca) atoms, and a magneto-optical trap using a transition from $^3P_2$ to $^3D_3$ for the atoms relaxed from $^1P_1$ state to $^3P_2$ metastable state, are used in combination. The transition from the $^3P_2$ level which is the metastable state to the $^3D_3$ level has a narrow linewidth, and long lifetime and cooling to a low temperature can be expected.

Non-Patent Literature 2 describes an experiment in which a magneto-optical trap using a transition from the ground state $^1S_0$ to an excited state $^1P_1$, and a magneto-optical trap using a transition from $^1S_0$ to $^3P_1$ for ytterbium (Yb), are used in combination. The former transition has a broad linewidth, and the latter transition has a narrow linewidth. By using both transitions in combination, it becomes possible to trap atoms with a relatively low magnetic field gradient compared to the case which uses a single transition, and simplification and cost reduction of the apparatus can be expected.

Non-Patent Literature 3 describes a two-stage laser cooling for strontium atoms, which can achieve a large capture velocity and low cooling temperature. Since the optimum magnetic fields is different for each magneto-optical trap, two-stage laser cooling at same space in the apparatus needs to be conducted by sequentially tuning both the magnetic field gradient and the laser parameters.

Sean Ravenhall et al., "a high-flux, adjustable, compact cold-atom source", Cornell University Library, 201 Olin Library Cornell University Ithaca, NY (2021-01-30), discloses the generation of an atomic beam through the apex of a pyramidal mirror according to a prior art of the present invention.

The two-stage cooling will now be described.

When atoms in each level are trapped in the magneto-optical trap, deceleration $a_0$ of atoms which can be trapped is described by the following Equation (1) according to the adiabatic condition.

[Equation 1]

$$a_0 \geq \frac{\Delta\mu}{\hbar} v_{max} \frac{dB}{dx}$$

Here, $\Delta\mu$ represents an effective magnetic moment of two levels between the upper state and the lower state, and dB/dz represents a magnetic gradient. A Doppler temperature $T_D$ of the trapped atoms is described by the following Equation (2).

[Equation 2]

$$k_B T_D = \frac{\hbar\gamma}{2}$$

The deceleration a0 is described by the following Equation (3).

[Equation 3]

$$a_0 = \frac{k_B k}{m} T_D$$

From Equations (1) and (3), the following Equation (4) is derived.

[Equation 4]

$$k_B T_D \geq \frac{m}{k} \frac{\Delta\mu}{\hbar} \frac{dB}{dx} v_{max}$$

When the transition to be used for the atomic cooling or the atomic trapping is selected, the linewidth ($\gamma$) of the transition is determined. Based on the linewidth, the Doppler temperature $T_D$ is uniquely determined from Equation (2), a maximum attainable deceleration is uniquely determined from Equation (3), and the magnetic field gradient is uniquely determined from Equation (1). For example, when it is desired to increase the magnetic field gradient and shorten a deceleration distance, a transition with a large linewidth is used, and as a consequence, the Doppler temperature inevitably becomes high. Further, for example, when it is desired to reduce the Doppler temperature, a transition with a narrow linewidth is used, and the magnetic field gradient inevitably becomes small.

In consideration of the fact that the maximum attainable deceleration differs depending on the transition, if it is possible to realize the above-described (1) and (2) in separate spaces and to apply an appropriate magnetic field gradient according to the respective levels of the atoms while applying the magnetic optical traps for a plurality of levels, efficient generation of atomic beams in a further cooled state can be expected.

CITATION LIST

PATENT LITERATURE

Patent Literature 1: JP 6206973 B
Patent Literature 2: JP 6635608 B
Patent Literature 3: JP 7189588 B

NON PATENT LITERATURE

Non-Patent Literature 1: J. Grünert et al., "Sub-Doppler magneto-optical trap for calcium", Phy. Rev. A 65(2002)041401
Non-Patent Literature 2: A. Kawasaki et al., "Two-color magneto-optical trap with small magnetic field for ytterbium", J. Phys. B Mol Opt. Phys. 48(2015) 155302
Non-Patent Literature 3: Hidetoshi Katori, Tetsuya Ido, Yoshitomo Isoya, and Makoto Kuwata-Gonokami, "Magneto-Optical Trapping and Cooling of Strontium Atoms down to the Photon Recoil Temperature", Phys. Rev. Lett. 82.1116.1999

SUMMARY

TECHNICAL PROBLEM

As described in Non-Patent Literature 3 described above, in the structure of the MOT apparatus of the related art, it has been difficult to realize the two-stage cooling with the same MOT apparatus.
An advantage of the present disclosure lies in realizing, in the same apparatus, a magneto-optical trap for an atom of a certain level and another magneto-optical trap for an atom at a level different from the certain level.

SOLUTION TO PROBLEM

According to one aspect of the present disclosure, there is provided a slow atomic beam generation apparatus comprising: a high-temperature tank including an atomic source, an optical window provided at one end and which passes laser light, and a mirror provided at the other end, which has an opening at an apex thereof, and which reflects laser light incident through the optical window toward the one end at portions other than the opening; a heater that heats the high-temperature tank, to generate an atomic gas in the high-temperature tank from the atomic source; a magnetic field generation apparatus that generates a magnetic field in a region where laser light reflected by the mirror intersects; and a magnetic field gradient attenuation module which locally attenuates a magnetic field gradient generated by magnetic field generator apparatus at the opening, wherein an atomic beam is formed from an atomic gas using a magneto-optical trap realized by laser light and a magnetic field, and is emitted to an outside through the opening.

According to the structure described above, the gradient of the magnetic field formed by the magnetic field generation apparatus is locally attenuated by the magnetic field gradient attenuation module at the opening. With this structure, a strong magnetic field gradient and a weak magnetic field gradient are formed, and different magneto-optical traps are formed by these magnetic field gradients. That is, a magneto-optical trap for an atom at a certain level and another magneto-optical trap for an atom at a level different from the certain level are realized. According to the structure described above, the traps can be realized by the same slow atomic beam generation apparatus.

The magnetic field generation apparatus may be an anti-Helmholtz coil which forms a magnetic field gradient, and the attenuation module may be a coil having a shape similar to the anti-Helmholtz coil, and in which a current flows in a direction opposite to that of the anti-Helmholtz coil.

The magnetic field generation apparatus may be a permanent magnet of a tubular shape which forms a magnetic field gradient, and the attenuation module may have a shape similar to the permanent magnet of the tubular shape, and may be polarized in a direction opposite to that of the permanent magnet of the tubular shape.

The magnetic field generation apparatus may form a magnetic field gradient, and the attenuation module may be formed from a soft magnet with high permeability, and may locally attenuates a magnetic field gradient therein by absorbing a magnetic flux therein.

The opening may be formed at a location other than a location on an axis of laser light.

The atomic source is, for example, strontium or ytterbium. With the use of the structure described above, it becomes possible to generate a slow atomic beam of strontium or ytterbium. Strontium and ytterbium are only exemplary, and, alternatively, even atoms with low vapor pressure at room temperature can be used if the heater temperature is set to a temperature at which sufficient vapor can be obtained.

The high-temperature tank has a 2n-axis-symmetrical right-angled polygonal pyramidal shape (wherein n is an integer greater than or equal to 2), or a right-angle quadrangular pyramidal shape. That is, the high-temperature tank may have a conical shape or a polygonal conical shape.

According to one aspect of the present disclosure, there is provided a physical package including the slow atomic beam generation apparatus described above, and a vacuum chamber surrounding a clock transition space in which the atom is placed.

According to one aspect of the present disclosure, there is provided a physical package for an optical lattice clock which includes the physical package.

According to one aspect of the present disclosure, there is provided a physical package for an atomic clock which includes the physical package.

According to one aspect of the present disclosure, there is provided a physical package for an atomic interferometer which includes the physical package.

According to one aspect of the present disclosure, there is provided a physical package for a quantum information processing device for atoms or for ionized atoms, which includes the physical package.

According to one aspect of the present disclosure, there is provided a physical package system which includes the physical package, and a control apparatus that controls an operation of the physical package.

ADVANTAGEOUS EFFECTS OF INVENTION

According to an aspect of the present disclosure, a magneto-optical trap for an atom at a certain level, and a magneto-optical trap for an atom at a level different from the certain level, may be realized in the same apparatus.

BRIEF DESCRIPTION OF DRAWINGS

FIG. 1 is a block diagram showing an overall structure of an optical lattice clock according to an embodiment of the present disclosure.
FIG. 2 is a diagram schematically showing a structure of a slow atomic beam generation apparatus according to a first embodiment of the present disclosure.
FIG. 3 is a diagram schematically showing a structure of the slow atomic beam generation apparatus according to the first embodiment of the present disclosure.
FIG. 4 is a perspective diagram showing a high-temperature tank and a magnetic field gradient attenuation module.
FIG. 5 is a perspective diagram showing a high-temperature tank and a magnetic field gradient attenuation module.
FIG. 6 is a diagram showing calculation results of a magnetic field distribution.
FIG. 7 is a diagram showing a magnetic field profile.
FIG. 8 is a diagram showing a magnetic field profile.
FIG. 9 is a diagram schematically showing a structure of the slow atomic beam generation apparatus according to the first embodiment of the present disclosure.
FIG. 10 is a diagram showing an energy levels and transitions in strontium atom.
FIG. 11 is a diagram schematically showing a structure of a slow atomic beam generation apparatus according to a second embodiment of the present disclosure.

DESCRIPTION OF EMBODIMENTS

<Structure of Optical Lattice Clock>

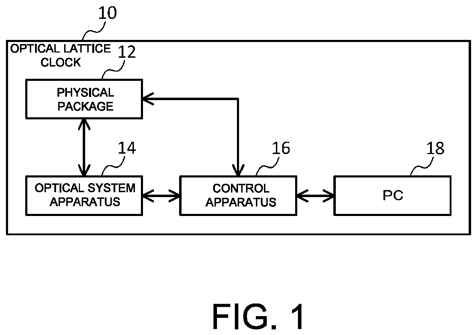

A schematic structure of an optical lattice clock 10 for which a slow atomic beam generation apparatus according to an embodiment of the present disclosure is used will now be described with reference to FIG. 1. FIG. 1 is a block diagram showing an overall structure of the optical lattice clock 10. Here, an optical lattice clock 10 will be described as an example of an apparatus for which the slow atomic beam generation apparatus is used, but alternatively, the slow atomic beam generation apparatus according to the present embodiment may be used for apparatuses other than the optical lattice clock 10.

The optical lattice clock 10 includes, for example, a physical package 12, an optical system apparatus 14, a control apparatus 16, and a PC (Personal Computer) 18.

The physical package 12 is an apparatus which traps atoms, confines the atoms in an optical lattice, and allows to interrogate of clock transition. The optical system apparatus 14 is an apparatus having optical devices such as a laser light source for trapping atoms, a laser light source for exciting clock transition, a laser frequency control apparatus, and the like. The optical system apparatus 14 applies processes, in addition to sending laser light to the physical package 12, to receive a fluorescence signal emitted from the atoms in the physical package 12, to convert the received signal into an electrical signal, and to feed back to the laser light source so that the frequency matches the resonance frequency of the atom. The control apparatus 16 is an apparatus which controls the physical package 12 and the optical system apparatus 14. The control apparatus 16 applies, for example, operation control of the physical package 12, operation control of the optical system apparatus 14, and an analysis process such as frequency analysis of the clock transition obtained through measurement. The physical package 12, the optical system apparatus 14, and the control apparatus 16 cooperate with each other, to realize the functions of the optical lattice clock 10.

The PC 18 is a general-purpose computer including one or more processors and a memory. Software is executed by hardware including the one or more processors and the memory, to realize the functions of the PC 18. In the PC 18, an application program for controlling the optical lattice clock 10 is installed. The PC 18 is connected to the control apparatus 16, and may control not only the control apparatus 16, but also the entirety of the optical lattice clock 10 including the physical package 12 and the optical system apparatus 14. In addition, the PC 18 provides a UI (User Interface) of the optical lattice clock 10. A user can start the optical lattice clock 10, apply time measurement, and check results through the PC 18.

A system including the physical package 12 and a structure necessary for control of the physical package 12 may sometimes be called a "physical package system". The structure necessary for the control may be included in the control apparatus 16 or in the PC 18, or in the physical package 12. Alternatively, a part or all of the functions of the control apparatus 16 may be included in the physical package 12.

A structure of a slow atomic beam generation apparatus according to an embodiment of the present disclosure will now be described

<Structure of Slow Atomic Beam Generation Apparatus of First Embodiment>

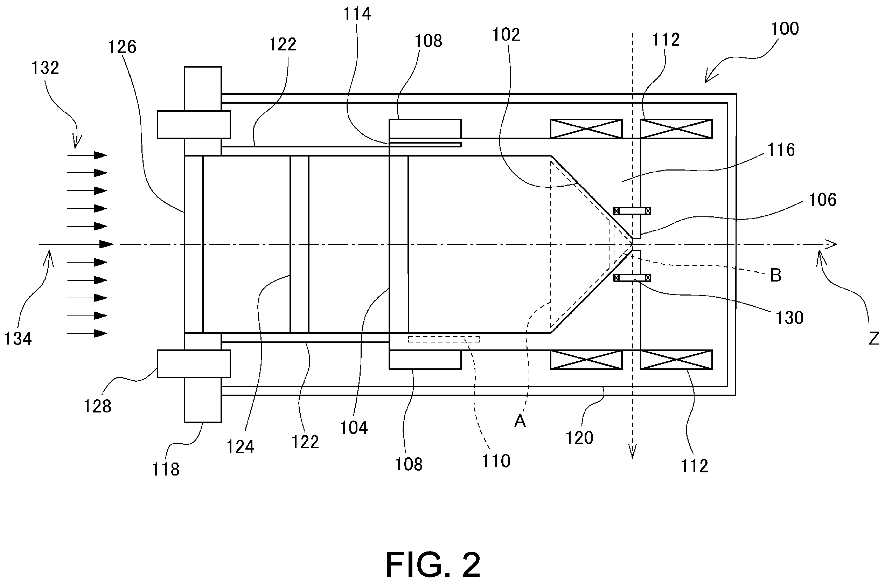

A structure of a slow atomic beam generation apparatus according to a first embodiment of the present disclosure will now be described with reference to FIG. 2. FIG. 2 is a diagram schematically showing a structure of a slow atomic beam generation apparatus 100 according to the first embodiment of the present disclosure. In the following, an axis parallel to a longitudinal direction of the slow atomic beam generation apparatus 100 will be called a "Z axis".

The slow atomic beam generation apparatus 100 generally includes a high-temperature part and a room-temperature part, and is an apparatus in which magnetic fields having different gradients are locally formed so as to realize a magneto-optical trap for an atom at a certain level, and another magneto-optical trap for an atom at a level different from the certain level.

The high-temperature part includes a right-angle conical mirror 102, an optical window 104, an opening 106, a heater 108, a sample 110, a magnetic field generation apparatus 112, a thermometer 114, and a high-temperature tank 116.

The room-temperature part includes a flange 118, a thermal radiation shield 120, a thermal insulation support bar 122, a cold filter window 124, a vacuum-resistant window 126, and a vacuum-resistant electrical connector 128.

The high-temperature part further includes a magnetic field gradient attenuation module 130.

The high-temperature tank 116 has an axially symmetric shape with respect to the Z axis. The high-temperature tank 116 has, for example, a 2n-axially symmetric shape (wherein n is an integer greater than or equal to 2) with respect to the Z axis. More specifically, the high-temperature tank 116 has a 2n-axially symmetric right-angle polygonal pyramidal shape (wherein n is an integer greater than or equal to 2). Alternatively, the high-temperature tank 116 may have a circular tubular shape, or a polygonal conical shape.

The high-temperature tank 116 includes the sample 110 which is an atomic source, the optical window 104 provided at one end and which passes laser light, and the right-angle conical mirror 102 provided at the other end. At an inside of the high-temperature tank 116, a space which is axially symmetric with respect to the Z axis is formed, and the right-angle circular conical mirror 102 is provided on an inner surface of the high-temperature tank 116, opposing the optical window 104 provided at the one end. When the high-temperature tank 116 has a 4-fold axially symmetric shape with respect to the Z axis, a right-angle quadrangular conical mirror is provided in place of the right-angle circular conical mirror 102. The right-angle circular conical mirror 102 reflects the laser light (laser light 132 to be described later) incident through the optical window 104 into the space inside the high-temperature tank 116 toward the optical window 104. The opening 106 is formed at an apex of the right-angle circular conical mirror 102. The opening 106 is a hole opened at the apex. Because the apex is placed on the Z axis, the opening 106 is placed on the Z axis. As will be described later, an atomic beam is emitted to the outside of the high-temperature tank 116 through the opening 106.

The thermometer 114 is provided on a side surface of the high-temperature tank 116, and measures the temperature of the high-temperature tank 116. The thermometer 114 is, for example, a thermocouple thermometer, a resistant thermometer using platinum or the like, etc.

The heater 108 which heats the high-temperature tank, and the magnetic field generation apparatus 112 which generates a magnetic field, are provided on an outer circumferential surface of the high-temperature tank 116. The magnetic field gradient attenuation module 130 is provided at an inner side of the magnetic field generation apparatus 112. The magnetic field gradient attenuation module 130 will be described later in detail.

The magnetic field generation apparatus 112 generates a magnetic field for trapping atoms using the magneto-optical trap (MOT) method, at an inside of the high-temperature tank 116. The magnetic field generation apparatus 112 may be provided on the outer circumferential surface of the high-temperature tank 116, or on an inner surface of the thermal radiation shield 120.

The magnetic field generation apparatus 112 is, for example, a coil. The coil is, for example, an anti-Helmholtz coil having an axially symmetric shape with respect to the Z axis, and in which a current flows anti-symmetrically with respect to the center axis. When the current flows in the coil, a uniform magnetic field gradient is formed. In order to form a large gradient magnetic field, it is necessary, for example, to wind a wire with a large diameter and a large number of turns to allow a large current. Alternatively, coils other than the above-described coil may be used.

When a setting temperature of the high-temperature tank 116 is lower than or equal to 250°C, a coated copper wire or the like which can endure the temperature is used as the coil.

When the slow atomic beam generation apparatus 100 is used in a high temperature environment, such as with the temperature of the high-temperature tank 116 set to 270°C, for example, a non-coated copper wire is used as the coil. For example, a bobbin formed from alumina ceramic or the like is used, grooves are formed on the bobbin such that adjacent copper wires do not contact each other, and the copper wires are wound on the bobbin using the grooves as guides.

As another example configuration, the magnetic field generation apparatus 112 may be a permanent magnet. The permanent magnet is, for example, a pair of permanent magnets having an axially symmetric ring shape, and polarized anti-symmetrically with respect to the center axis. As another example configuration, the permanent magnet may be a permanent magnet having an axially symmetric circular cylindrical shape covering the high-temperature tank 116, and magnetized in a radial direction. Alternatively, permanent magnets other than those described above may be employed. A uniform magnetic field gradient is formed by the permanent magnet.

In addition, a permanent magnet having a sufficiently large Curie temperature in comparison to the setting temperature is used. For example, a samarium-cobalt magnet, an Alnico magnet, a strontium-ceramic magnet, or the like is used as the permanent magnet of the present embodiment.

The magnetic field generation apparatus 112 forms a quadrupole magnetic field distribution suited for the right-angle conical mirror 102. The high-temperature tank 116 may have a right-angle quadrangular pyramid shape in place of the right-angle conical shape. That is, a right-angle quadrangular pyramid mirror may be used in place of the right-angle conical mirror 102.

As another example configuration, the magnetic field generation apparatus 112 may be an assembly of 2n rectangular- or saddle-shaped coils (wherein n is an integer greater than or equal to 2) with same dimension, located on a side surface (outer circumferential surface of the high-temperature tank 116) surrounding a 2n-rotationally symmetric axis (wherein n is an integer greater than or equal to 2) of the high-temperature tank 116. For example, the controller 16 generates a two-dimensional quadrupole magnetic field from the magnetic field generator 112 by applying the currents between the coils facing each other across the 2n rotational symmetry axis in opposite directions.

As yet another example configuration, the magnetic field generation apparatus 112 may be 2n quadrangular prism-shape or circular arc prism-shape permanent magnets (permanent magnets of a prism shape with a cross section of a quadrangle or a circular arc) having the same shape, provided on a side surface (outer circumferential surface of the high-temperature tank 116) surrounding the 2n-rotational symmetry axis of the high-temperature tank 116. The permanent magnet is magnetized in an angular direction (circumferential direction surrounding the axis of symmetry) with respect to the axis of symmetry. In addition, the magnetization directions of permanent magnets facing each other with the 2n-rotational symmetry axis therebetween are opposite to each other. In this manner, the quadrupole magnetic field is formed.

The heater 108 heats the high-temperature tank 116 so that the high-temperature tank 116 reaches the setting temperature. For example, the heater 108 heats a part or the entirety of the high-temperature tank 116. With the heating by the heater 108, the state of the atomic source transitions from a solid phase to a gas phase, and the atomic gas is thus generated, and is discharged to the space inside the high-temperature tank 116. In addition, with the heating by the heater 108, it is possible to prevent re-condensation of the atomic gas when the atomic gas collides with an inner wall or the like of the optical window 104 or the high-temperature tank 116. The role of transitioning the state of the atomic source from the solid phase to the gas phase may alternatively be realized by laser ablation, in place of the heater 108.

The sample 110 includes the atomic source, and is housed in a small chamber provided on a side surface of an inner wall of the high-temperature tank 116. The sample 110 may be introduced into and taken out through the opening 106, or by disassembling the slow atomic beam generation apparatus and removing the optical window.

For a material of the high-temperature tank 116, a material is used so that the high-temperature tank 116 does not chemically react with the atomic gas at the setting temperature, and which does not form an alloy with the atomic gas.

The temperature of the high-temperature tank 116 is set so that a saturation vapor pressure of the sample 110 is sufficiently large in comparison to the degree of vacuum of the environment in which the sample 110 is placed, and a saturation vapor pressure of a heated site such as the high-temperature tank 116 is sufficiently small. For example, when the atomic source is strontium (Sr), the setting temperature of the high-temperature tank 116 is set at 270°C.

Materials of the right-angle conical mirror 102 and the high-temperature tank 116 are, for example, aluminum, a metal coated with aluminum, an insulator coated with aluminum, silver, a metal coated with silver, an insulator coated with silver, SUS (stainless steel), or glass with an optical multilayer film coating. The insulator is, for example, ceramic (for example, high-purity alumina or the like), or glass.

A material of the right-angle conical mirror 102 may be the same material as that of the high-temperature tank 116 or may be different therefrom. For example, when the material of the right-angle conical mirror 102 is the same as that of the high-temperature tank 116, a surface which is to function as the right-angle conical mirror 102 may be mechanically polished to finish the surface into a mirror surface. When the material of the right-angle conical mirror 102 differs from that of the high-temperature tank 116, a surface which is to function as the right-angle circular conical mirror 102 may be coated with aluminum plating, silver plating, or the like. Alternatively, the surface which is to function as the right-angle conical mirror 102 may be coated with optical multilayer film.

As the materials of the right-angle circular conical mirror 102 and the high-temperature tank 116, for example, a material which has a low vapor pressure in a state of being heated to the setting temperature and which suppresses an amount of discharge gas under an ultra-high vacuum is used. As the materials of the right-angle conical mirror 102 and the high-temperature tank 116, a material may be employed such that the right-angle conical mirror 102 has a sufficient reflectance with respect to the laser light which is incident (laser light 132 to be described later) in the state of being heated to the setting temperature, such that the surface of the right-angle conical mirror 102 does not chemically react with the atomic gas, such that the material does not form an alloy with the atomic gas, and such that a sufficient reflectance can be maintained. In addition, the surface of the right-angle circular conical mirror 102 is polished so that a surface roughness of the right-angle circular conical mirror 102 is sufficiently small with respect to a wavelength of the incident laser light.

As a material of the optical window 104, a material which maintains transparency at the setting temperature (for example, sapphire) is used. Alternatively, a film which can maintain the transparency at the setting temperature may be formed over the optical window 104 formed from sapphire. For example, a titanium oxide alloy/silica-based multilayer layered film may be formed over the optical window 104 through electron beam deposition.

The thermal radiation shield 120 is placed to prevent thermal radiation to components placed at a periphery of the slow atomic beam generation apparatus 100. The thermal radiation shield 120 is provided to cover the heater 108, the magnetic field generation apparatus 112, and the high-temperature tank 116. That is, the heater 108, the magnetic field generation apparatus 112, and the high-temperature tank 116 are placed within a space surrounded by the thermal radiation shield 120. For example, materials with low surface emissivity (e.g. mirror-finished aluminum, mirror-finished stainless steel) are used. Alternatively, a plurality of thermal radiation shields 120 may be placed in an overlapped manner. For example, when a double sheet is used, an outer sheet may be formed from a material having a high magnetic permeability such as permalloy, so as to realize both functions of the thermal radiation shield and an electromagnetic shield.

Windows are placed on the Z axis in the order of the optical window 104, the cold filter window 124, and the vacuum-resistant window 126. The optical window 104 is provided at the one end of the high-temperature tank 116, opposing the right-angle circular conical mirror 102.

A material of the vacuum-resistant window 126 is, for example, Pyrex (registered trademark) glass, quartz glass, or the like. Alternatively, a film which can maintain the transparency, such as an anti-reflective coating, may be applied over the surface of the vacuum-resistant window 126.

The cold filter window 124 is coated with a coating for increasing reflectivity at a center wavelength of a spectrum of thermal radiation from the high-temperature part, the cold filter window 124 is provided between the optical window 104 and the vacuum-resistant window 126 on an optical path of the laser light incident through the optical window 104, and the cold filter window 124 prevents thermal radiation heat transfer from the optical window 104 to the vacuum-resistant window 126. Alternatively, a reflection prevention coating [with respect to laser light incident through the optical window 104] may be applied to the cold filter window 124. A material of the cold filter window 124 is, for example, the same material as that for the vacuum-resistant window 126. Alternatively, a heat ray cutting filter may be used in place of the cold filter window 124.

The thermal insulation support bar 122 is provided from the high-temperature tank 116 to the flange 118. As a material of the thermal insulation support bar 122, a material of a low heat conductivity is used in order to prevent thermal conduction heat transfer from the high-temperature part to the room-temperature part, to improve the thermal efficiency of the heater of the high-temperature part, and to maintain stability of the temperature of the room-temperature part. For example, magnesia, steatite ceramic, or the like is used as the material of the thermal insulation support bar 122.

The vacuum-resistant electrical connector 128 is a hermetic connector for transmitting and receiving electrical signals between vacuum space and atmospheric space. The vacuum-resistant electrical connector 128 is used, for example, for inputting and outputting signals of the thermometer 114, for supplying the current to the heater 108, and for supplying the current to the magnetic field generation apparatus 112. For the convenience of explanation, FIG. 2 does not show the wirings.

The flange 118 is a member for attaching the slow atomic beam generation apparatus 100 onto a physical package of the atomic clock apparatus such as the optical lattice clock 10, and an atomic interferometer apparatus, or onto a physical package of a quantum computer apparatus which uses atoms as qubits. The physical package includes a vacuum container, the high-temperature tank 116 of the slow atomic beam generation apparatus 100 is used under an ultra-high vacuum environment, and the inside of the high-temperature tank 116 is maintained at the ultra-high vacuum. For this purpose, the flange 118 has a sealing mechanism for sealing the vacuum such as, for example, a metal gasket method. There is a possibility that heat may be transferred from the high-temperature part to the flange 118. In consideration of such a possibility, a water-cooling mechanism may be provided on the flange 118.

The magnetic field gradient attenuation module 130 will now be described. The magnetic field gradient attenuation module 130 is placed at a position further inward than the magnetic field generation apparatus 112 (that is, at a position nearer to the opening 106 than the magnetic field generation apparatus 112), and in a narrower range in the Z-axis direction than the magnetic field generation apparatus 112, and locally attenuates the gradient of the magnetic field generated by the magnetic field generation apparatus 112 at the opening 106 or a periphery thereof. In addition, the magnetic field gradient attenuation module 130 is not placed in a region surrounded by the high-temperature tank 116, that is, in a region in which the right-angle circular conical mirror 102 is formed, and is placed on the high-temperature tank 116. With such a configuration, the laser light 132 is incident on the right-angle conical mirror 102 without being blocked by the magnetic field gradient attenuation module 130, and is reflected by the right-angle conical mirror 102.

At the inside of the high-temperature tank 116, a space axially symmetric with respect to the Z axis is formed. In the example configuration illustrated in FIG. 2, regions A and B shown with broken lines are formed. The regions A and B are regions surrounded by the high-temperature tank 116. The region B is a region nearer to the opening 106 than the region A, and the region A is a region distanced from the opening 106 than the region B.

The magnetic field generation apparatus 112 is designed to form a magnetic field gradient which is as uniform as possible, in the inside space of the high-temperature tank 116 (that is, a space including the regions A and B). The magnetic field gradient attenuation module 130 is designed to locally form the magnetic field gradient in the region B without affecting the magnetic field in the region A. That is, the magnetic field gradient attenuation module 130 is designed to form the magnetic field gradient in the region B which is narrower than the overall region including the regions A and B in which the magnetic field is formed by the magnetic field generation apparatus 112, and at an inside of the overall region. For example, the magnetic field gradient attenuation module 130 is provided at a periphery of the opening 106 with the Z axis as an axial center, and forms the magnetic field gradient in the region B.

The magnetic field gradient attenuation module 130 has, for example, a shape similar to the magnetic field generation apparatus 112, and is designed to realize a magnetic pole having an opposite sign to the magnetic pole formed by the magnetic field generation apparatus 112.

For example, when the magnetic field generation apparatus 112 is the anti-Helmholtz coil with the Z axis as an axial center, the magnetic field gradient attenuation module 130 is an anti-Helmholtz coil having a shape similar to the anti-Helmholtz coil, and is placed at the periphery of the opening 106, with the Z axis as an axial center. Directions of current flowing in the coils are set such that currents in opposite directions flow in the anti-Helmholtz coil of the magnetic field generation apparatus 112 and the anti-Helmholtz coil of the magnetic field gradient attenuation module 130. That is, the directions of the currents of the coils are set such that a current flows in a direction opposite to the direction of the current flowing in the anti-Helmholtz coil of the magnetic field generation apparatus 112 flows in the anti-Helmholtz coil of the magnetic field gradient attenuation module 130.

As another example configuration, when the magnetic field generation apparatus 112 is the tubular permanent magnet magnetized in the radial direction, the magnetic field gradient attenuation module 130 is a tubular permanent magnet having a shape similar to the tubular permanent magnet, and magnetized in an opposite direction to the permanent magnet of the magnetic field generation apparatus 112.

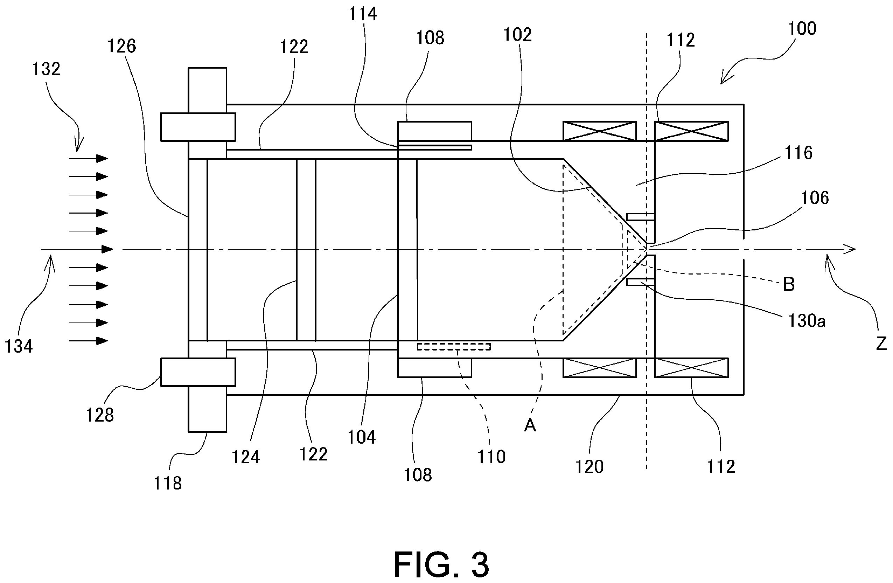

As a further example configuration, the magnetic field gradient attenuation module is a soft magnet having a high magnetic permeability, such as permalloy. FIG. 3 shows a slow atomic beam generation apparatus in which the soft magnet is used. A magnetic field gradient attenuation module 130a illustrated in FIG. 3 is the soft magnet. The soft magnet having the high magnetic permeability absorbs the magnetic flux at the periphery thereof. The magnetic flux of the absorbed portion is locally attenuated. For example, the magnetic field gradient attenuation module 130a is formed from an annular soft magnet, and is placed apart from the center of the quadrupole magnetic field formed by the magnetic field generation apparatus 112 by a distance that is almost the same as the radius of the quadrupole magnetic field. The magnetic field gradient attenuation module formed from the annular soft magnet may be placed such that an axis thereof is parallel to the center axis of the magnetic field generation apparatus 112, and center points of the magnetic field gradient attenuation module and the magnetic field generation apparatus 112 coincide with each other.

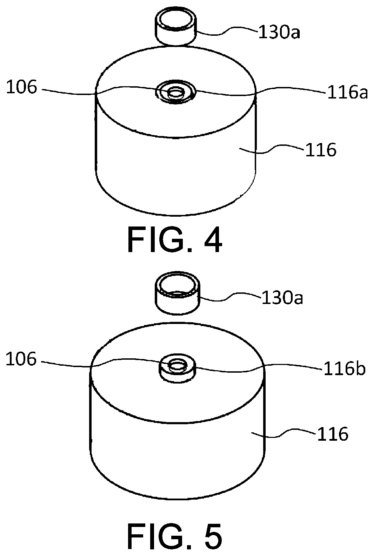

FIG. 4 shows a specific example structure in which the magnetic field gradient attenuation module is attached to the high-temperature tank 116. FIG. 4 is a perspective diagram showing the high-temperature tank 116 and the magnetic field gradient attenuation module 130a formed from the soft magnet. A groove 116a surrounding the opening 106 is formed on the high-temperature tank 116, at the periphery of the opening 106. The ring-shaped magnetic field gradient attenuation module 130a is fitted to the groove 116a. Alternatively, the magnetic field gradient attenuation module 130 formed from the permanent magnet and having a ring shape may be fitted to the groove 116a.

FIG. 5 shows another specific example structure. FIG. 5 is a perspective diagram showing the high-temperature tank 116, and the magnetic field gradient attenuation module 130a formed from the soft magnet. On the high-temperature tank 116, a protrusion 116b surrounding the opening 106 is formed at the periphery of the opening 106. The magnetic field gradient attenuation module 130a of the ring shape is fitted to the protrusion 116b. Alternatively, the magnetic field gradient attenuation module 130 formed from the permanent magnet and having the ring shape may be fitted to the protrusion 116b.

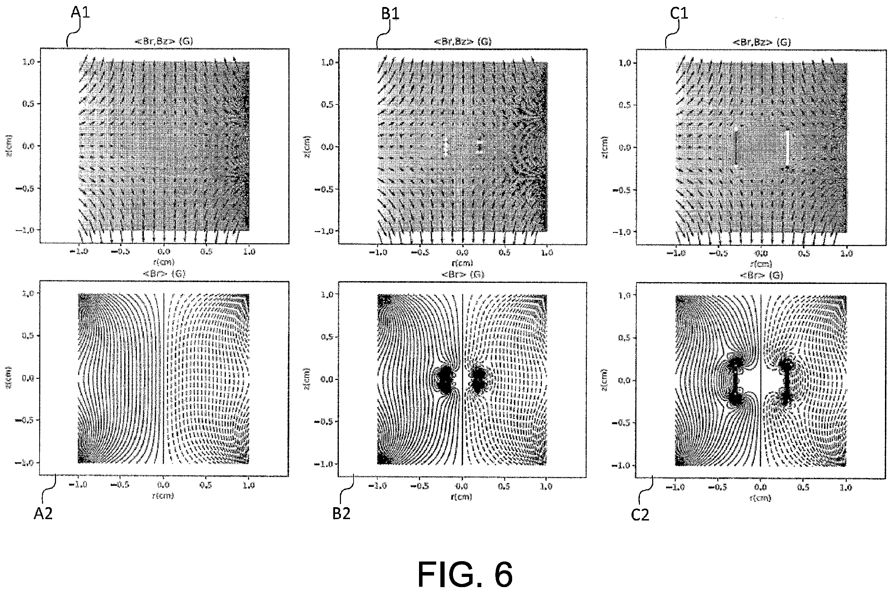

FIG. 6 shows calculation results of a magnetic field distribution formed by the magnetic field generation apparatus 112 and the magnetic field gradient attenuation module 130. Calculation results A1 and A2 are calculation results of the magnetic field distribution formed by the magnetic field generation apparatus 112. Calculation results B1 and B2 are calculation results when the magnetic field gradient attenuation module 130 formed from two aligned ring-shaped soft magnets is used, and are calculation results of the magnetic field distribution formed by the magnetic field generation apparatus 112 and the magnetic field gradient attenuation module 130. Calculation results C1 and C2 are calculation results when the magnetic field gradient attenuation module 130 formed from the tubular soft magnet is used, and are calculation results of the magnetic field distribution formed by the magnetic field generation apparatus 112 and the magnetic field gradient attenuation module 130.

The calculation results A1, B1, and C1 show magnetic field maps representing a strength of the magnetic field in a gray scale. The calculation results A2, B2, and C2 show contour lines of the magnetic field.

In the calculation results A1 and A2, for example, contour lines with a uniform spacing are formed in a radial direction (horizontal axis) at Z=0 (vertical axis), and it can be understood that a uniform magnetic field gradient is formed. On the other hand, in the calculation results B1, B2, C1, and C2, it can be understood that, while contour lines which are not different to the calculation results A1 and A2 are formed at positions distanced from the center, at positions near the center a region of sparse contour lines is formed, that is, a region in which the magnetic field gradient is locally attenuated is formed.

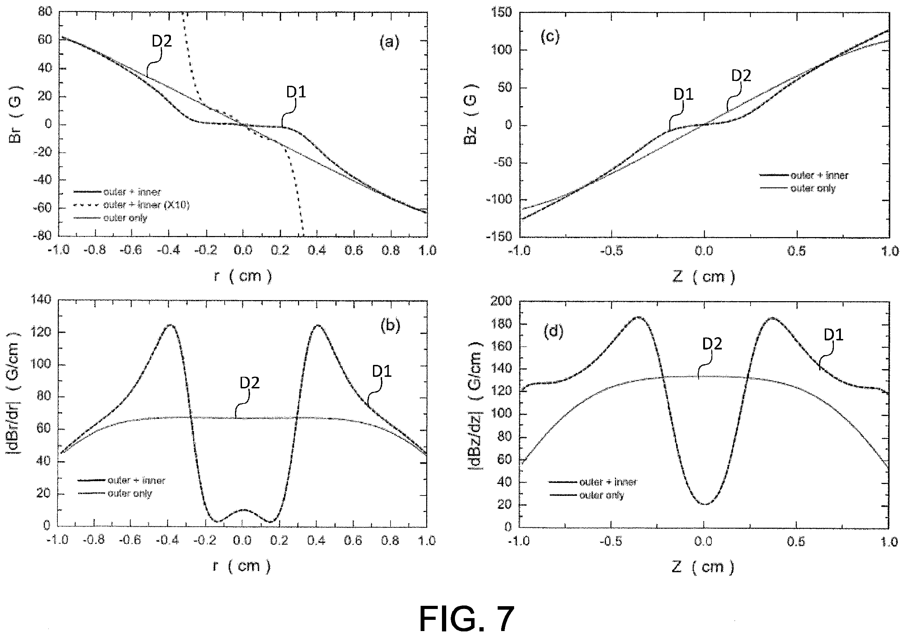

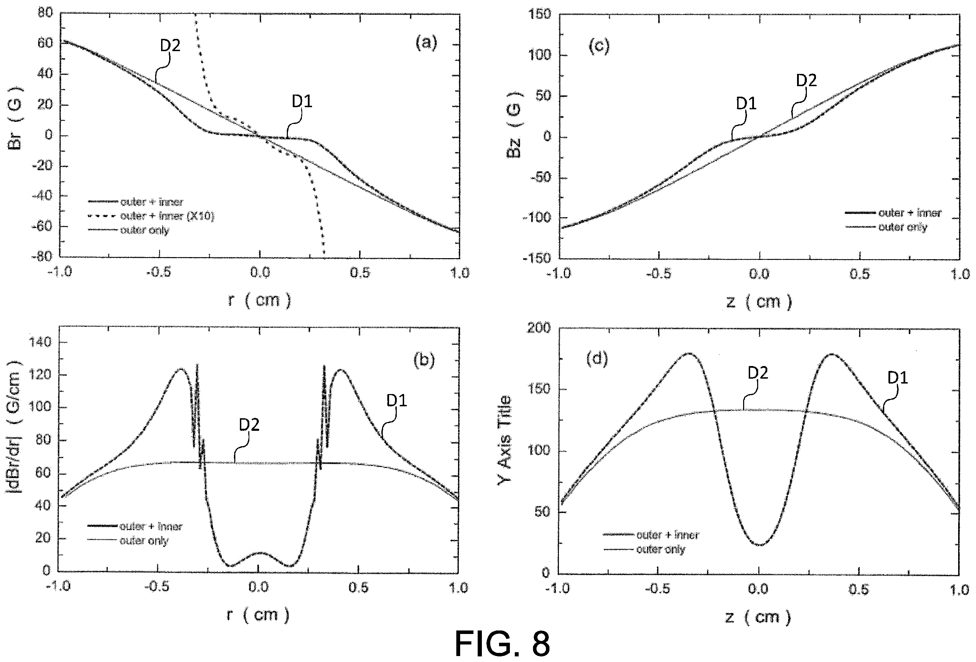

FIG. 7 shows magnetic field profiles corresponding to the calculation results B1 and B2. FIG. 8 shows magnetic field profiles corresponding to the calculation results C1 and C2. In (a) and (c) in FIGs. 7 and 8, the vertical axis represents the magnetic field, and, in (b) and (d), the vertical axis represents the gradient of the magnetic field. In (a) and (b) in FIGs. 7 and 8, the horizontal axis represents a distance in the radial direction, and in (c) and (d), the horizontal axis represents a distance in the Z-axis direction.

A profile D1 in FIGs. 7 and 8 is a magnetic field profile formed by the magnetic field generation apparatus 112 and the magnetic field gradient attenuation module 130. A profile D2 is a magnetic field profile formed solely by the magnetic field generation apparatus 112 without the use of the magnetic field gradient attenuation module 130. It can be understood that the magnetic field gradient is locally attenuated with the use of the magnetic field gradient attenuation module 130.

As described, by providing the magnetic field generation apparatus 112 and the magnetic field gradient attenuation module 130, a strong magnetic field gradient is formed in the region A and a weak magnetic field gradient is formed in the region B. That is, in the region B, a locally weak magnetic field gradient is formed by the strong magnetic field gradient formed by the magnetic field generation apparatus 112 being locally attenuated by the magnetic field gradient attenuation module 130.

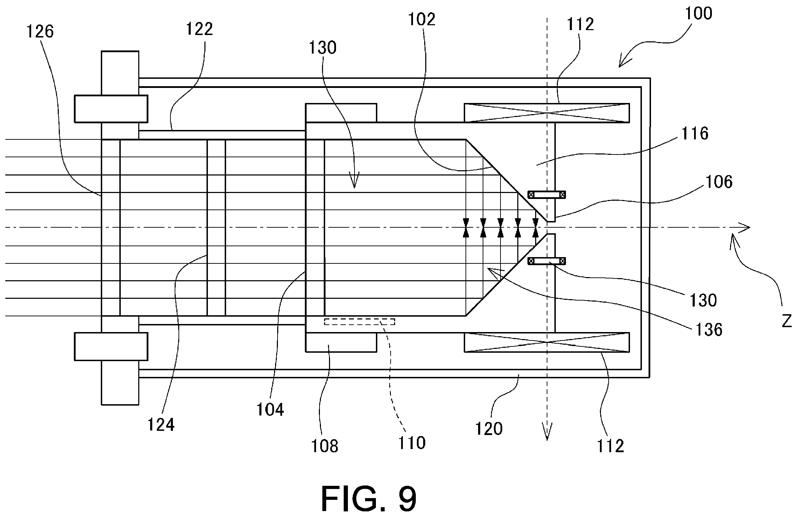

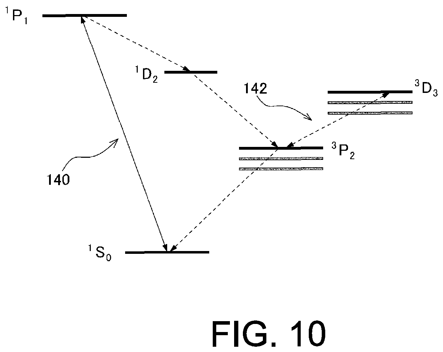

An operation of the slow atomic beam generation apparatus 100 will now be described with reference to FIGs. 2, 9, and 10. FIG. 9 is a diagram schematically showing a structure of the slow atomic beam generation apparatus according to the first embodiment of the present disclosure. FIG. 10 is a diagram showing an energy levels and transitions in strontium atom.

As shown in FIGs. 2 and 9, the laser light 132 transmits from outside of the slow atomic beam generation apparatus 100 through the vacuum-resistant window 126, and enters the slow atomic beam generation apparatus 100. The laser light 132 has a circular polarization (for example, σ+). The laser light 132 entering the slow atomic beam generation apparatus 100 transmits through the cold filter window 124 and the optical window 104, and is twice reflected by the right-angle conical mirror 102 in the high-temperature tank 116 (refer to arrows 136). The reflected laser light 132 has a circular polarization opposite from the incoming path (for example, σ-), transmits through the optical window 104, the cold filter window 124, and the vacuum-resistant window 126, and is emitted to the outside of the slow atomic beam generation apparatus 100.

The laser light 134 shown in FIG. 2 is a push laser light, transmits along an X axis from the outside of the slow atomic beam generation apparatus 100 through the vacuum-resistant window 126, and enters the slow atomic beam generation apparatus 100.

With the high-temperature tank 116 being heated by the heater 108, the atomic source is heated, and, as a consequence, atoms are evaporated and discharged into the inside space of the high-temperature tank 116. The atomic gas is trapped in the high-temperature tank 116 using the magneto-optical trap, and is cooled.

A gradient magnetic field is formed in the inside space (region including the regions A and B) of the high-temperature tank 116 by the magnetic field generation apparatus 112, and the magnetic field gradient in the region B is locally attenuated by the magnetic field gradient attenuation module 130. For example, a magnetic field and a magnetic field gradient as shown by the magnetic field profile D1 in FIG. 7 or 8 are formed.

A trap space for trapping the atoms is formed inside the high-temperature tank 116 by the reflected laser light 132 and the magnetic field formed by the magnetic field generation apparatus 112 and the magnetic field gradient attenuation module 130, and a magneto-optical trap (MOT) for trapping the atoms is thus realized.

With reference to FIG. 10, the magneto-optical trap will be described in detail. First, with a magneto-optical trap using the energy transition shown with arrow 140, atoms are trapped in radial direction in the region A shown in FIG. 2. A part of the atoms trapped in the region A reaches the region B by laser light 134 which is a push laser light, and is trapped by the magneto-optical trap using the energy transition shown with reference numeral 142 in FIG. 10, and is cooled to a further lower temperature.

In other words, a magneto-optical trap using a transition from the ground state $^1S_0$ to the excited state $^1P_1$ and a magneto-optical trap using a transition from $^3P_2$ to $^3D_3$ for atoms transitioned from $^1P_1$ to $^3P_2$, which is a metastable state, are realized in the same slow atomic beam generation apparatus 100. The transition from the $^3P_2$ level which is a metastable state to the $^3D_3$ level has a narrow linewidth , and long lifetime and cooling to a low temperature can be expected.

The atoms trapped and cooled using the magneto-optical trap in this manner are output from the opening 106 to the outside of the high-temperature tank 116 by the laser light 134 which is the push laser light. A slow atomic beam is formed by the atoms which are output in this manner. In addition, on the thermal radiation shield 120, an opening is formed on the Z axis, and the slow atomic beam emitted from the high-temperature tank 116 to the outside is emitted to the outside of the thermal radiation shield 120 through the opening formed on the thermal radiation shield 120.

According to the slow atomic beam generation apparatus 100, in addition to the sample 110, the entirety of the high-temperature tank 116 including the optical window 104 is heated. Because of this, even for elements which have a low saturation vapor pressure at the room temperature and for which sufficient atomic gas cannot be obtained, the saturation vapor pressure can be increased by the heating, and sufficient atomic gas can thus be obtained. For example, strontium may be used as the atomic source. Even when strontium is used as the atomic source, by the high-temperature tank 116 being heated to about 270°C, sufficient atomic gas can be obtained. In addition, using the magneto-optical trap, a cooled atomic beam of a high flow rate can be generated. Alternatively, as the element having a low saturation vapor pressure at the room temperature, elements other than strontium may be used. For example, ytterbium may be used as the atomic source.

In addition, because the periphery of the high-temperature tank 116 which is heated is covered by the thermal radiation shield 120 and the cold filter window 124 except for the opening 106 through which the slow atomic beam is output, the thermal radiation emanating from the high-temperature part can be suppressed.

For reducing the size of the slow atomic beam generation apparatus, a length of the thermal insulation support bar 122, which is primarily responsible for the heat conduction between the high-temperature part and the room-temperature part, is an important parameter. As a material of the thermal insulation support bar 122, magnesia (MgO) is suitable, in consideration of a small amount of out gas under the UHV environment. A number of thermal insulation support bars 122 is desirably 3, from the viewpoint of heat discharge. However, the number is only exemplary, and the number of the thermal insulation support bars 122 may be other than 3. As a material of the high-temperature tank 116, aluminum is desirably used, which has a high reflectance and which does not tend to chemically react with the atomic gas. With the use of aluminum, which is a light metal, as the material, the weight of the slow atomic beam generation apparatus can be reduced, and a risk of deformation of the support can be reduced.

<Structure of Slow Atomic Beam Generation Apparatus according to Second Embodiment>

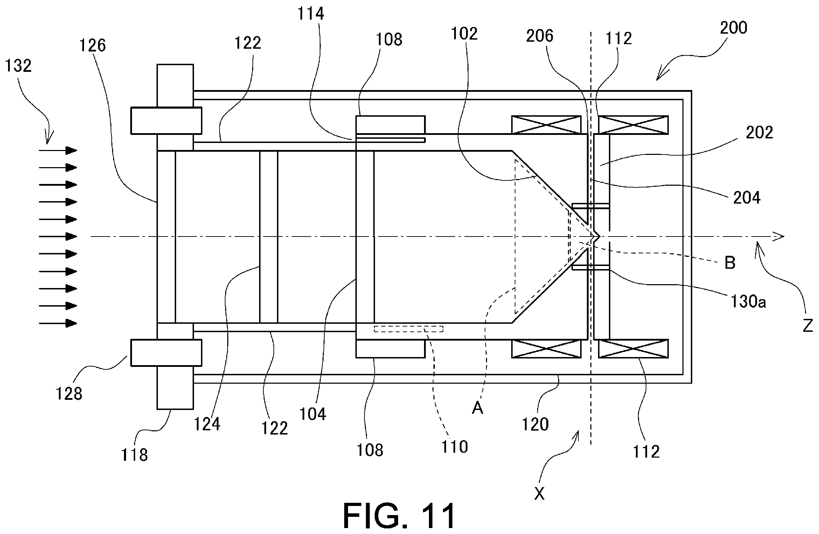

With reference to FIG. 11, a structure of a slow atomic beam generation apparatus according to a second embodiment of the present disclosure will now be described. FIG. 11 is a diagram schematically showing a structure of a slow atomic beam generation apparatus 200 according to the second embodiment.

The slow atomic beam generation apparatus 200 according to the second embodiment of the present disclosure includes a high-temperature tank 202 in place of the high-temperature tank 116 of the slow atomic beam generation apparatus 100 according to the first embodiment of the present disclosure. The structures of the slow atomic beam generation apparatus 200 other than the high-temperature tank 202 are identical to those of the slow atomic beam generation apparatus 100. Thus, in the following, the structure of the high-temperature tank 202 will be described, and the description of structures other than the high-temperature tank 202 will be omitted. FIG. 11 shows, as the magnetic field gradient attenuation module, a magnetic field gradient attenuation module 130a formed from a soft magnet, but alternatively, the magnetic field gradient attenuation module 130 may be used.

On an inner surface of the high-temperature tank 202, the right-angle conical mirror 102 is provided, similar to the first embodiment. In the second embodiment of the present disclosure, the opening 106 is not formed at the apex of the right-angle conical mirror 102, and a passageway 204 extending along the X axis orthogonal to the Z axis is formed near the apex. The passageway 204 extends along the X axis, and passes through the high-temperature tank 202.

Similar to the first embodiment, a gradient magnetic field is formed in the inside space (region including the regions A and B) of the high-temperature tank 202 by the magnetic field generation apparatus 112, and the magnetic field gradient in the region B is locally attenuated by the magnetic field gradient attenuation module 130a (or the magnetic field gradient attenuation module 130).

An optical lattice light beam is illuminated in the passageway 204, and by changing the wavelength of the optical lattice light beam slightly, it is possible to set the optical lattice to a direction of propagation of the optical lattice light beam. With a moving means of the moving optical lattice, the atoms trapped in the region B can be moved in the passageway 204. The atoms moved in the passageway 204 are output to the outside through an opening 206. A slow atomic beam is formed by the atoms which are output in this manner.

According to the second embodiment, similar to the slow atomic beam generation apparatus 100 of the first embodiment, the two-stage cooling can be realized in the same slow atomic beam generation apparatus 200. In addition, according to the second embodiment, there is an advantage that the laser light 132 used for the magneto-optical trap does not leak to the outside through the opening 106.

<Structure of Physical Package 12>

The physical package 12 of the optical lattice clock according to the present embodiment will now be described. The physical package 12 includes the slow atomic beam generation apparatus 100 according to the first embodiment of the present disclosure, a vacuum chamber surrounding a clock transition space in which atoms are placed, and a mechanism which realizes the magneto-optical trap and the clock transition within the vacuum chamber 6. An operation of the physical package 12 will now be described.

In the physical package 12, an inside of the vacuum chamber is made into vacuum. A slow atomic beam sufficiently decelerated by the slow atomic beam generation apparatus 100 is emitted from the slow atomic beam generation apparatus 100, and reaches the magneto-optical trap apparatus (MOT apparatus) in the vacuum chamber. In the MOT apparatus, a magnetic field having a linear spatial gradient is formed, centered at the trapping space where the atoms are trapped, and MOT light is illuminated. With this configuration, the atoms are trapped in the trapping space. The slow atomic beam reaching the MOT apparatus is decelerated in the trapping space, and the atoms are trapped in the trapping space. In addition, the optical lattice light beam is incident to the trapping space, and is reflected by an optical resonator provided in the vacuum chamber, so that an optical lattice potential in which standing waves are combined is formed in the direction of propagation of the optical lattice light beam. The atoms are trapped in the optical lattice potential.

By changing the wavelength slightly, the optical lattice may be moved in the direction of propagation of the optical lattice light beam. With this moving means by the moving optical lattice, the trapped atoms moved to a clock transition spectral region. As a result, the clock transition space is set off the beam axis of the slow atomic beam.

In the clock transition space, laser light in which the light frequency is controlled is illuminated to the atoms, high-precision spectroscopy of the clock transition (that is, resonance transition of the atom which forms a basis of the clock) is performed, and a frequency which is unique for the atom and which is unchanging is measured. With this process, an accurate atomic clock is realized. When it is not necessary to move the atoms from the trapping space to the clock transition space, the spectroscopy may be performed in the trapping space.

In order to improve the precision of the atomic clock, it is necessary to remove perturbation around the atom, and to accurately read the frequency. Particularly important is removal of the frequency shift caused by a Doppler effect due to thermal motion of the atom. In the optical lattice clock, the motion of the atoms is frozen by entrapping the atoms with the optical lattice created by interference of the laser light, in a space which is sufficiently small in comparison to the wavelength of the clock laser. On the other hand, in the optical lattice, the frequency of the atom is shifted by the laser light forming the optical lattice. Thus, a particular wavelength and a particular frequency which are respectively called a "magic wavelength" and a "magic frequency" are selected for the optical lattice light beam, to remove the influences of the optical lattice on the resonance frequency.

The light emitted as a result of the clock transition is received by the optical system apparatus 14, a spectroscopy process or the like is applied by the control apparatus 16, and the frequency is determined.

Alternatively, the slow atomic beam generation apparatus 200 according to the second embodiment may be used in place of the slow atomic beam generation apparatus 100 according to the first embodiment.

In the above description, the optical lattice clock has been exemplified. However, those skilled in the art can apply the techniques of the embodiments to applications other than the optical lattice clock. More specifically, the technique may be applied to atomic clocks other than the optical lattice clock, or to an atomic interferometer which is an interferometer which uses atoms. For example, a physical package for an atomic clock may be constructed including the slow atomic beam generation apparatus according to the embodiments of the present disclosure, and a vacuum chamber, or a physical package for an atomic interferometer may be constructed. In addition, the present embodiment may be applied to various quantum information processing devices for atoms or ionized atoms. A quantum information processing device refers to an apparatus which applies measurement, sensing, and information processes using quantum states of atoms and light, and examples thereof include, in addition to the atomic clock and the atomic interferometer, a magnetic field meter, an electric field meter, a quantum computer, a quantum simulator, and a quantum relay. In the physical package of the quantum information processing device, a size reduction or transportability may be realized similar to the physical package for the optical lattice clock, by utilizing the techniques of the embodiments of the present disclosure. It should be noted that, in these devices, the clock transition space may sometimes be handled simply as a space in which the clock transition spectral separation occurs, and not as a space targeted to the time measurement.

In these devices, with the use of the slow atomic beam generation apparatuses according to the embodiments of the present disclosure, elements which have a low saturation vapor pressure at room temperature and for which sufficient atomic gas cannot be obtained may be used. In addition, size reduction and transportability may be realized for these devices.

In the above description, a specific configuration is shown in order to facilitate understanding. The specific configuration, however, is only exemplary for the embodiment, and various other embodiments may be employed.

REFERENCE SIGNS LIST

10 optical lattice clock, 12 physical package, 14 optical system apparatus, 16 control apparatus, 100, 200 slow atomic beam generation apparatus, 102 right-angle conical mirror, 104 optical window, 106 opening, 108 heater, 110 sample, 112 magnetic field generation apparatus, 116 high-temperature tank, 120 thermal radiation shield, 130, 130a magnetic field gradient attenuation module, 132, 134 laser light

**Claims**

1. A slow atomic beam generation apparatus (100) comprising:

   a high-temperature tank (116) including an atomic source, an optical window (104) provided at one end and which passes laser light, and a mirror (102) provided at the other end, which has an opening at an apex thereof, and which reflects laser light incident through the optical window toward the one end at portions other than the opening;
   a heater (108) that heats the high-temperature tank, to generate an atomic gas in the high-temperature tank from the atomic source;
   a magnetic field generation apparatus (112) that generates a magnetic field in a region where laser light reflected by the mirror intersects; and
   a magnetic field gradient attenuation module (130) which locally attenuates a magnetic field gradient generated by magnetic field generator apparatus at the opening, wherein an atomic beam is formed from an atomic gas using a magneto-optical trap realized by laser light and a magnetic field, and is emitted to an outside through the opening.

2.  The slow atomic beam generation apparatus according to claim 1, wherein

    the magnetic field generation apparatus (112) is an anti-Helmholtz coil which forms a magnetic field gradient, and
    the attenuation module (130) is a coil having a shape similar to the anti-Helmholtz coil, and in which a current flows in a direction opposite to that of the anti-Helmholtz coil.

3.  The slow atomic beam generation apparatus according to claim 1, wherein

    the magnetic field generation apparatus (112) is a permanent magnet of a tubular shape which forms a magnetic field gradient, and
    the attenuation module (130) has a shape similar to the permanent magnet of the tubular shape, and is polarized in a direction opposite to that of the permanent magnet of the tubular shape.

4.  The slow atomic beam generation apparatus according to claim 1, wherein

    the magnetic field generation apparatus (112) forms a magnetic field gradient, and
    the attenuation module (130) is formed from a soft magnet with high magnetic permeability, and locally attenuates a magnetic field gradient therein by absorbing a magnetic flux therein.

5.  The slow atomic beam generation apparatus according to any one of claims 1 to 4, wherein the opening (106) is formed at a location other than a location on an axis of laser light.

6.  The slow atomic beam generation apparatus according to any one of claims 1 to 5, wherein the atomic source is strontium.

7.  The slow atomic beam generation apparatus according to any one of claims 1 to 5, wherein the atomic source is ytterbium.

8.  The slow atomic beam generation apparatus according to any one of claims 1 to 7, wherein the high-temperature tank (116) has a 2n-axis-symmetrical right-angled polygonal pyramidal shape, wherein n is an integer greater than or equal to 2.

9.  The slow atomic beam generation apparatus according to any one of claims 1 to 7, wherein the high-temperature tank (116) has a right-angle quadrangular pyramid shape.

10. A physical package (12) comprising:

    the slow atomic bean generation apparatus (100) according to any one of claims 1 to 9; and
    a vacuum chamber surrounding a clock transition space in which atoms are placed.

11. A physical package for an optical lattice clock, comprising:
    the physical package (12) according to claim 10.

12. A physical package for an atomic clock, comprising:
    the physical package (12) according to claim 10.

13. A physical package for an atomic interferometer, comprising:
    the physical package (12) according to claim 10.

14. A physical package for a quantum information processing device for atoms or ionized atoms, the physical package (12) comprising:
    the physical package according to claim 10.

15. A physical package system comprising:

    the physical package (12) according to claim 10; and
    a control apparatus that controls an operation of the physical package.

**Patentansprüche**

1.  Einrichtung (100) zum Erzeugen eines langsamen Atomstrahls, umfassend:

    einen Hochtemperaturbehälter (116), der eine Atomquelle, ein an einem Ende bereitgestelltes optischen Fenster (104), das Laserlicht durchlässt, und einen an dem anderen Ende bereitgestellten Spiegel (102) beinhaltet, der an seiner Spitze eine Öffnung aufweist und Laserlicht, das durch das optische Fenster einfällt, in Richtung des einen Endes an anderen Abschnitten als der Öffnung reflektiert;
    ein Heizgerät (108), das den Hochtemperaturbehälter erwärmt, um in dem Hochtemperaturbehälter ein Atomgas aus der Atomquelle zu erzeugen;
    eine Magnetfelderzeugungseinrichtung (112), die ein Magnetfeld in einem Bereich erzeugt, in dem sich von dem Spiegel reflektiertes Laserlicht kreuzt; und

ein Magnetfeldgradienten-Dämpfungsmodul (130), das einen von der Magnetfelderzeugungseinrichtung an der Öffnung erzeugten Magnetfeldgradienten lokal abschwächt, wobei ein Atomstrahl aus einem Atomgas unter Verwendung einer magneto-optischen Falle erzeugt wird, die durch Laserlicht und ein Magnetfeld realisiert wird, und durch die Öffnung nach außen emittiert wird.

2. Einrichtung zum Erzeugen eines langsamen Atomstrahls nach Anspruch 1, wobei

die Magnetfelderzeugungseinrichtung (112) eine Anti-Helmholtz-Spule ist, die einen Magnetfeldgradienten erzeugt, und
das Dämpfungsmodul (130) eine Spule ist, die eine Form aufweist, die der der Anti-Helmholtz-Spule ähnelt, und in der ein Strom in entgegengesetzter Richtung zu der der Anti-Helmholtz-Spule fließt.

3. Einrichtung zum Erzeugen eines langsamen Atomstrahls nach Anspruch 1, wobei

die Magnetfelderzeugungseinrichtung (112) ein Permanentmagnet in einer Röhrenform ist, der einen Magnetfeldgradienten bildet, und
das Dämpfungsmodul (130) eine ähnliche Form wie der Permanentmagnet der Röhrenform aufweist und in einer Richtung, die der des Permanentmagneten der Röhrenform entgegengesetzt ist, polarisiert ist.

4. Einrichtung zum Erzeugen eines langsamen Atomstrahls nach Anspruch 1, wobei

die Magnetfelderzeugungseinrichtung (112) einen Magnetfeldgradienten bildet, und
das Dämpfungsmodul (130) aus einem weichmagnetischen Material mit hoher magnetischer Permeabilität gebildet ist und lokal einen darin befindlichen Magnetfeldgradienten durch Absorbieren eines darin befindlichen magnetischen Flusses dämpft.

5. Einrichtung zum Erzeugen eines langsamen Atomstrahls nach einem der Ansprüche 1 bis 4, wobei die Öffnung (106) an einer anderen Stelle als auf einer Achse des Laserlichts gebildet ist.

6. Einrichtung zum Erzeugen eines langsamen Atomstrahls nach einem der Ansprüche 1 bis 5, wobei die atomare Quelle Strontium ist.

7. Einrichtung zum Erzeugen eines langsamen Atomstrahls nach einem der Ansprüche 1 bis 5, wobei die atomare Quelle Ytterbium ist.

8. Einrichtung zum Erzeugen eines langsamen Atomstrahls nach einem der Ansprüche 1 bis 7, wobei der Hochtemperaturbehälter (116) eine 2n-achsensymmetrische rechtwinklige polygonale Pyramidenform aufweist, wobei n eine Ganzzahl größer oder gleich 2 ist.

9. Einrichtung zum Erzeugen eines langsamen Atomstrahls nach einem der Ansprüche 1 bis 7, wobei der Hochtemperaturbehälter (116) eine rechtwinklige viereckige Pyramidenform aufweist.

10. Physisches Gehäuse (12), das Folgendes umfasst:

die Einrichtung (100) zum Erzeugen eines langsamen Atomstrahls nach einem der Ansprüche 1 bis 9; und
eine Vakuumkammer, die einen Uhrübergangsraum umgibt, in dem Atome platziert sind.

11. Physisches Gehäuse für eine optische Gitteruhr, die Folgendes umfasst:
das physische Gehäuse (12) nach Anspruch 10.

12. Physisches Gehäuse für eine Atomuhr, das Folgendes umfasst:
das physische Gehäuse (12) nach Anspruch 10.

13. Physisches Gehäuse für ein Atominterferometer, das Folgendes umfasst:
das physische Gehäuse (12) nach Anspruch 10.

14. Physisches Gehäuse für eine Quanteninformationsverarbeitungsvorrichtung für Atome oder ionisierte Atome, wobei das physische Gehäuse (12) Folgendes umfasst:
das physische Gehäuse nach Anspruch 10.

15. Physisches Gehäusesystem, das Folgendes umfasst:

das physische Gehäuse (12) nach Anspruch 10; und
eine Steuereinrichtung, die einen Betrieb des physischen Gehäuses steuert.

**Revendications**

1. Appareil de génération de faisceau atomique lent (100) comprenant :

un réservoir à haute température (116) comprenant une source atomique, une fenêtre optique (104) disposée à une extrémité et qui laisse passer la lumière laser, et un miroir (102) disposé à l'autre extrémité, qui présente une ouverture à son sommet et qui réfléchit la lumière laser incidente à travers la fenêtre optique vers l'une extrémité dans des parties autres que l'ouverture ;

un élément chauffant (108) qui chauffe le réservoir à haute température, pour générer un gaz atomique dans le réservoir à haute température à partir de la source atomique ;

un appareil de génération de champ magnétique (112) qui génère un champ magnétique dans une région où la lumière laser réfléchie par le miroir se croise ; et

un module d'atténuation de gradient de champ magnétique (130) qui atténue localement un gradient de champ magnétique généré par appareil générateur de champ magnétique au niveau de l'ouverture, dans lequel

un faisceau atomique est formé à partir d'un gaz atomique à l'aide d'un piège magnéto-optique réalisé par la lumière laser et un champ magnétique, et est émis vers l'extérieur à travers l'ouverture.

2. Appareil de génération de faisceau atomique lent selon la revendication 1, dans lequel

l'appareil de génération de champ magnétique (112) est une bobine anti-Helmholtz qui forme un gradient de champ magnétique, et

le module d'atténuation (130) est une bobine présentant une forme similaire à la bobine anti-Helmholtz, et dans laquelle un courant circule dans une direction opposée à celle de la bobine anti-Helmholtz.

3. Appareil de génération de faisceau atomique lent selon la revendication 1, dans lequel

l'appareil de génération de champ magnétique (112)· est un aimant permanent de forme tubulaire qui forme un gradient de champ magnétique, et

le module d'atténuation (130) présente une forme similaire à celle de l'aimant permanent de forme tubulaire et est polarisé dans une direction opposée à celle de l'aimant permanent de forme tubulaire.

4. Appareil de génération de faisceau atomique lent selon la revendication 1, dans lequel

l'appareil de génération de champ magnétique (112) forme un gradient de champ magnétique, et

le module d'atténuation (130) estformé à partir d'un aimant doux à haute perméabilité magnétique et atténue localement un gradient de champ magnétique en absorbant un flux magnétique dans celui-ci.

5. Appareil de génération de faisceau atomique lent selon l'une quelconque des revendications 1 à 4, dans lequel

l'ouverture (106) est formée à un emplacement autre qu'un emplacement sur un axe de lumière laser.

6. Appareil de génération de faisceau atomique lent selon l'une quelconque des revendications 1 à 5, dans lequel

la source atomique est le strontium.

7. Appareil de génération de faisceau atomique lent selon l'une quelconque des revendications 1 à 5, dans lequel

la source atomique est l'ytterbium.

8. Appareil de génération de faisceau atomique lent selon l'une quelconque des revendications 1 à 7, dans lequel

le réservoir haute température (116) présente une forme pyramidale polygonale à angle droit symétrique par rapport à 2n axes, dans lequel n est un entier supérieur ou égal à 2.

9. Appareil de génération de faisceau atomique lent selon l'une quelconque des revendications 1 à 7, dans lequel

le réservoir haute température (116) présente une forme de pyramide quadrangulaire à angle droit.

10. Emballage physique (12) comprenant :

l'appareil de génération de faisceau atomiques lents (100) selon l'une quelconque des revendications 1 à 9 ; et

une chambre à vide entourant un espace de transition d'horloge dans lequel sont placés des atomes.

11. Emballage physique pour une horloge à réseau optique, comprenant :

l'emballage physique (12) selon la revendication 10.

12. Emballage physique pour une horloge atomique, comprenant :

l'emballage physique (12) selon la revendication 10.

13. Emballage physique pour un interféromètre atomique, comprenant :

l'emballage physique (12) selon la revendication 10.

14. Emballage physique pour un dispositif de traitement d'information quantique pour atomes ou atomes ionisés, l'emballage physique (12) comprenant :

l'emballage physique selon la revendication 10.

15. Système d'emballage physique comprenant :

l'emballage physique (12) selon la revendication 10 ; et
un appareil de commande qui commande un fonctionnement de l'emballage physique.

FIG. 1

FIG. 2

FIG. 3

**FIG. 4**

**FIG. 5**

FIG. 6

FIG. 7

FIG. 8

FIG. 9

EP 4 322 344 B1

FIG. 10

FIG. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6206973 B
- JP 6635608 B
- JP 7189588 B

**Non-patent literature cited in the description**

- **SEAN RAVENHALL et al.** a high-flux, adjustable, compact cold-atom source. Cornell University Library, 201 Olin Library Cornell University, 30 January 2021
- **J. GRÜNERT et al.** Sub-Doppler magneto-optical trap for calcium. *Phy. Rev. A*, 2002, vol. 65, 041401
- **A. KAWASAKI et al.** Two-color magneto-optical trap with small magnetic field for ytterbium. *J. Phys. B Mol Opt. Phys.*, 2015, vol. 48, 155302
- **HIDETOSHI KATORI ; TETSUYA IDO ; YOSHITO-MO ISOYA ; MAKOTO KUWATA-GONOKAMI**. Magneto-Optical Trapping and Cooling of Strontium Atoms down to the Photon Recoil Temperature. *Phys. Rev. Lett.*, vol. 82 (1116), 1999